# EUROPEAN PATENT APPLICATION

(11) **EP 2 222 149 A1**
(43) Date of publication of application: **25.08.2010**
(21) Application number: 10154189.4
(22) Date of filing: 22.02.2010
(51) Int. Cl.: H05K 3/36, H05K 1/14, H01L 23/538

(54) **Electronic component mounting structure and electronic component mounting method**

(30) Priority: 24.02.2009 JP 2009040930
(71) Applicant: FUJITSU LIMITED, Kawasaki-shi, Kanagawa 211-8588 (JP)
(72) Inventor: Takada, Rie, KAWASAKI-SHI, KANAGAWA 211-8588 (JP); Tsubone, Kenichiro, KAWASAKI-SHI, KANAGAWA 211-8588 (JP)
(74) Representative: Kreutzer, Ulrich

(57) **Abstract**

An electronic component mounting structure includes a first substrate (11) on which a first component (12) is mounted and a second substrate (15) connected to the first substrate. The second substrate is bent toward the first component.

## Description

### FIELD

The present invention relates to an electronic component mounting structure and an electronic component mounting method.

### BACKGROUND

Recently, with the multifunction and high performance of semiconductor devices, the number of components which are mounted on a substrate is increasing. In addition, downsizing requests for a semiconductor device unit are being accelerated with the downsizing of electronic equipment where the semiconductor device unit is incorporated. Therefore, component mounting density is increasing, and it is difficult to ensure a sufficient mounting area.

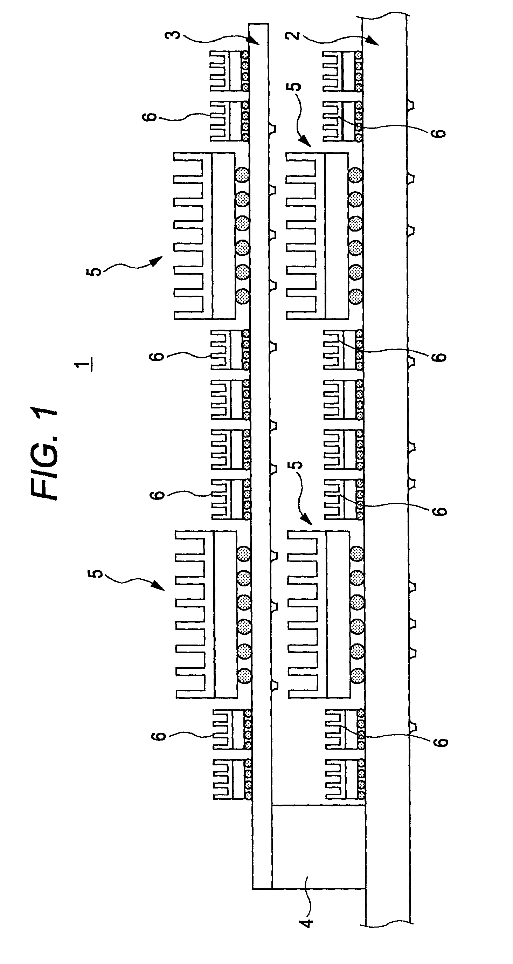

Hence, in Japanese Laid-Open Patent Application Publication No. 2002-359448, a plurality of circuit boards is stacked as depicted in Fig. 1, which improves a mounting efficiency. The semiconductor device unit 1 has a structure in which first and second printed circuit boards 2 and 3 are stacked via a stack connector 4. Ball grid array (BGA) type integrated circuits 5 and memory devices 6 are mounted and packaged onto the first and second printed circuit boards 2 and 3.

However, in the structure in which the first and second printed substrates 2 and 3 are stacked, electrical properties in signal transmission deteriorate when the semiconductor device unit 1 is for handling a high-speed signal.

That is to say, when the BGA type integrated circuit 5 is the semiconductor device responding to the high-speed signal, wiring length between the BGA type integrated circuit 5 mounted on the first printed substrate 2 located on a lower portion and the BGA type integrated circuit 5 mounted on the second printed substrate 3 located on an upper portion becomes longer. Therefore, in the semiconductor device unit 1 in which the first and second printed substrates 2 and 3 are stacked, high-speed properties in the signal transmission are deteriorated.

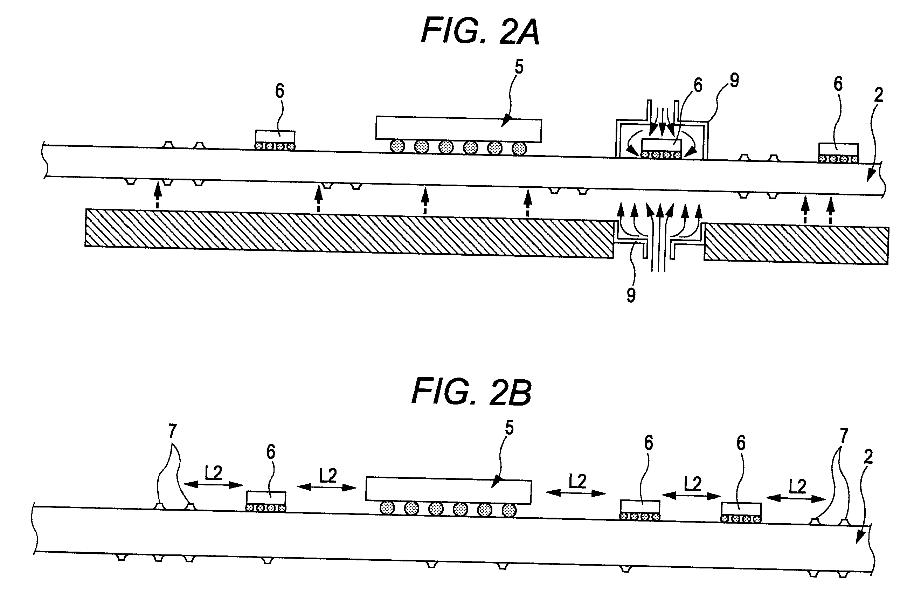

On the other hand, in the semiconductor device unit 1, when a defect occurs in the mounted component, a process (repair) to change a defective product to a non-defective product is performed. At the time of this repair process, as depicted in Fig. 2A, a cover 9 is provided on a component to be changed (small BGA 6 in this drawing) and solder is melted by supplying high-temperature air in the cover 9, thereby detaching the small BGA 6 from the first printed substrate 2.

Therefore, a certain distance is provided between the components such that the heat at the time of repair does not affect the component in the vicinity of the small BGA 6 to be repaired (the distance is indicated by an arrow L2 in Fig. 2B). Conventionally, the distance L is set on the first printed substrate 2, so that this also is responsible for lowering the mounting density of the components.

### SUMMARY

According to the described embodiments, an electronic component mounting structure includes a first substrate on which a first component is mounted and a second substrate connected to the first substrate. The second substrate is bent toward the first component.

It is to be understood that both the foregoing general description and the following detailed description are exemplary, and do not restrict the invention as claimed.

### BRIEF DESCRIPTION OF DRAWINGS

The above and other features and advantages of the present invention will become apparent from the following description of the embodiments in conjunction with the accompanying drawings, wherein:
Fig. 1 is a front view illustrating a semiconductor device unit according to related art;
Figs. 2A and 2B are views illustrating a semiconductor device unit according to related art;
Fig. 3 is a front view of the semiconductor device unit according to a first embodiment;
Fig. 4 is a plane view of the semiconductor device unit according to the first embodiment;
Fig. 5 is an enlarged view of a BGA type integrated circuit of the semiconductor device unit according to the first embodiment;
Fig. 6 is a view illustrating a repair method in the semiconductor device unit according to the first embodiment;
Figs. 7A-7D are first views illustrating a method of manufacturing the semiconductor device unit according to the first embodiment;
Figs. 8A-8D are second views illustrating the method of manufacturing the semiconductor device unit according to the first embodiment;
Figs. 9A and 9B are views illustrating a first modified example of the semiconductor device unit and the method of manufacturing the same according to the first embodiment;
Figs. 10A and 10B are views illustrating a second modified example of the semiconductor device unit and the method of manufacturing the same according to the first embodiment;
Figs. 11A-11C are views illustrating a third modified example of the semiconductor device unit and the method of manufacturing the same according to the first embodiment;
Fig. 12 is a front view of the semiconductor device unit according to a second embodiment;
Figs. 13A and 13B are enlarged views of the BGA type integrated circuit of the semiconductor device unit according to the second embodiment;
Fig. 14 is a front view of the semiconductor device unit according to a third embodiment;
Fig. 15 is an enlarged view of the BGA type integrated circuit of the semiconductor device unit according to the third embodiment;
Figs. 16A and 16B are views illustrating a repair method in the semiconductor device unit according to the third embodiment;
Figs. 17A and 17B are views illustrating a method of manufacturing the semiconductor device unit according to the third embodiment;
Figs. 18A and 18B are views illustrating the method of manufacturing the semiconductor device unit according to the third embodiment;
Fig. 19 is a view illustrating the method of manufacturing the semiconductor device unit according to the third embodiment;
Fig. 20 is a view illustrating a modified example of the semiconductor device unit according to the third embodiment; and
Fig. 21 is a view illustrating the modified example of the semiconductor device unit according to the third embodiment.

### DESCRIPTION OF EMBODIMENTS

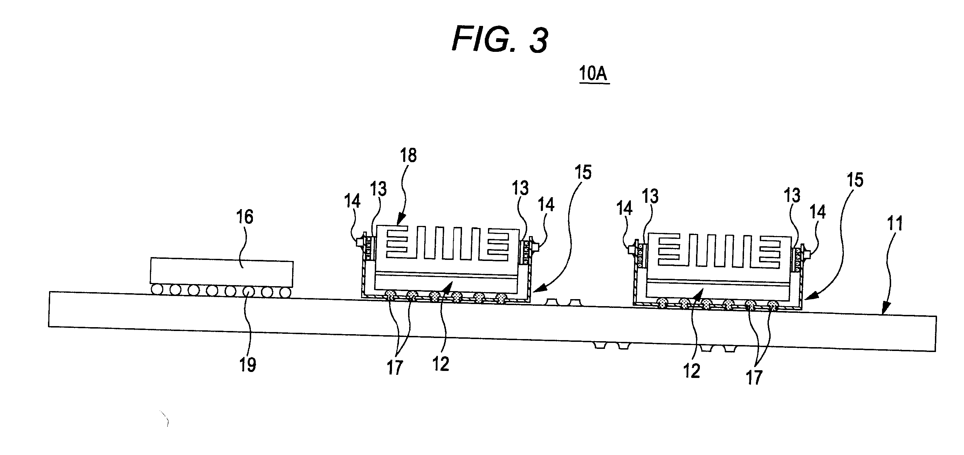

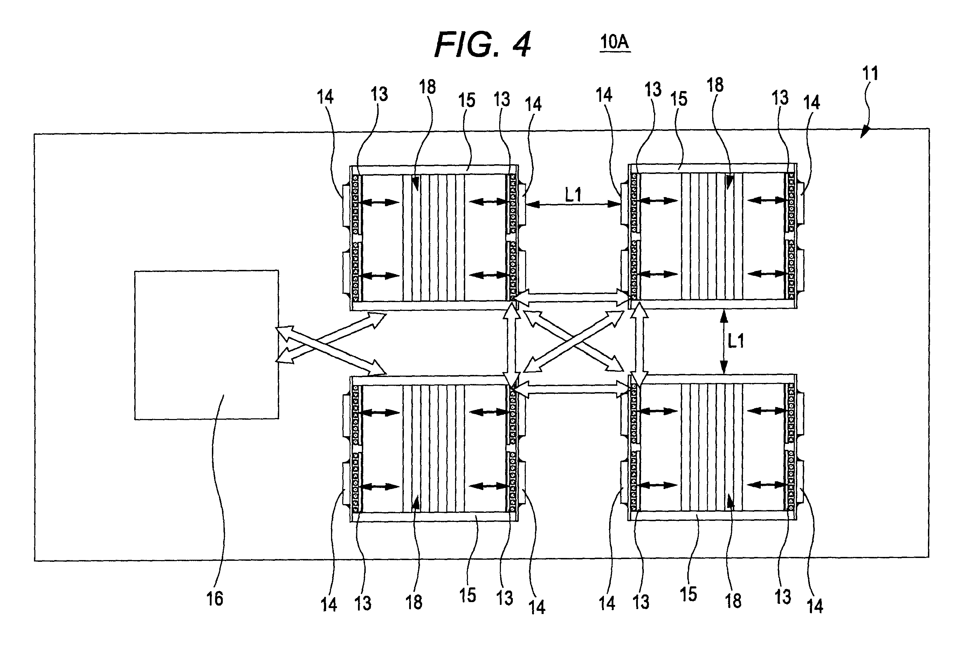

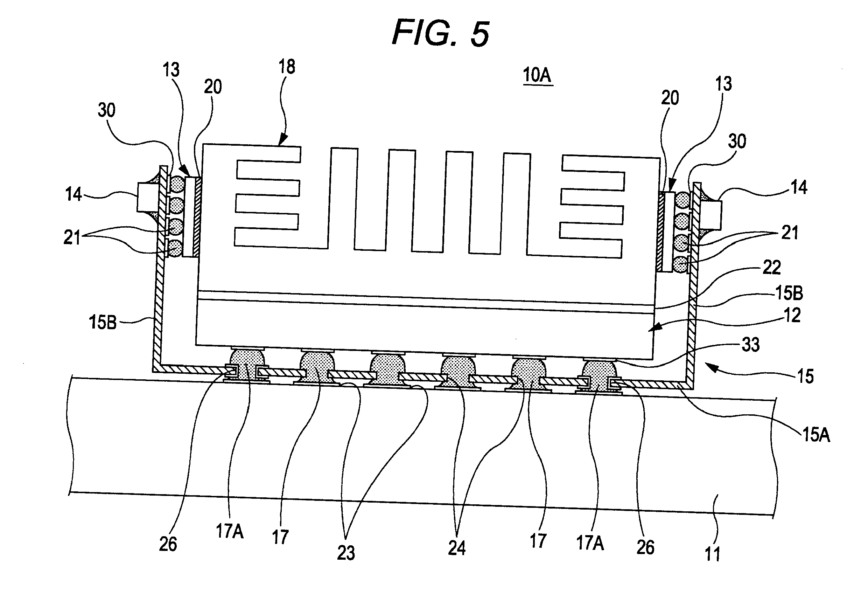

Figs. 3 and 4 are views illustrating a semiconductor device unit 10A according to a first embodiment. Fig. 3 is a front view of the semiconductor device unit 10A, Fig. 4 is a plane view of the semiconductor device unit 10A, and Fig. 5 is an enlarged view of one BGA type integrated circuit 12 mounted on the semiconductor device unit 10A.

The semiconductor device unit 10A has a printed wiring substrate 11, the BGA type integrated circuit 12, a memory device 13, a flexible printed circuit board 15, an electronic component 16 (such as a communication device) and the like. The semiconductor device unit 10A is mounted on an electronic device for performing a high-speed signal process, such as a server used in a communication network.

The printed wiring substrate 11 being a first substrate is a multilayer printed wiring substrate in which a plurality of insulating layers and wiring layers are stacked and the wiring layers are interlayer-connected to each other by means of a via or a through-hole (hereinafter, they are collectively referred to as the via) (wiring layers and via are not shown). On a surface of the printed wiring substrate 11, a substrate electrode 23 for mounting the BGA type integrated circuit 12 and the electronic component 16 is formed. The substrate electrode 23 is connected to the above-described wiring layer using the via. Meanwhile, although an example in which the printed wiring substrate 11 is used as the substrate of the semiconductor device unit 10A is shown in this embodiment, it is also possible to use another substrate such as a multilayer ceramic substrate.

The BGA type integrated circuit 12 being a first component is a semiconductor device for performing a variety of control processes in the server. Since the server is required to realize a high-speed process, the BGA type integrated circuit 12 responds to the high-speed process. The semiconductor device for performing the high-speed process emits intense heat during operation thereof. Therefore, a radiating fin 18 is mounted on an upper surface of the BGA type integrated circuit 12.

The radiating fin 18 is fixed to the upper surface of the BGA type integrated circuit 12 using an adhesive 22 having high thermal conductivity. The radiating fin 18 is formed of a material having high thermal conductivity such as aluminum. Also, the radiating fin 18 has a plurality of fins (blades) for improving heat radiation properties. Further, in this embodiment, a shape of the radiating fin 18 in a plane view is set to be substantially identical to a shape of the BGA type integrated circuit 12 in a plane view.

Also, the BGA type integrated circuit 12 has a number of electrodes (referred to as device side electrodes 33) so as to perform a variety of control processes in the server. Therefore, the BGA type integrated circuit 12 applies a ball grid array (BGA) structure, which enables a highly dense structure, to a terminal structure of the device. In the BGA type integrated circuit 12, a connection terminal 17 is provided on the substrate electrode 23, and the BGA type integrated circuit 12 is mounted on the printed wiring substrate 11 by connection of the connection terminal 17 to the substrate electrode 23 of the printed wiring substrate 11.

In this embodiment, four BGA type integrated circuits 12 are mounted on the printed wiring substrate 11, as depicted in Fig. 4. The four BGA type integrated circuits 12 are electrically connected to one another through the wiring layer (inner wiring) formed in the printed wiring substrate 11. The BGA type integrated circuits 12 are required to be arranged close to one another so as to reduce transmission loss of a signal communicated among them.

The memory device 13 being a second component is a buffer memory connected to the BGA type integrated circuit 12. In this embodiment, the memory device 13 also applies the BGA structure to the terminal structure. It is desirable that the memory device 13 is arranged close to the BGA type integrated circuit 12 in terms of increasing a processing speed of the BGA type integrated circuit 12. The memory device 13 is mounted on a second substrate, the flexible printed circuit board 15.

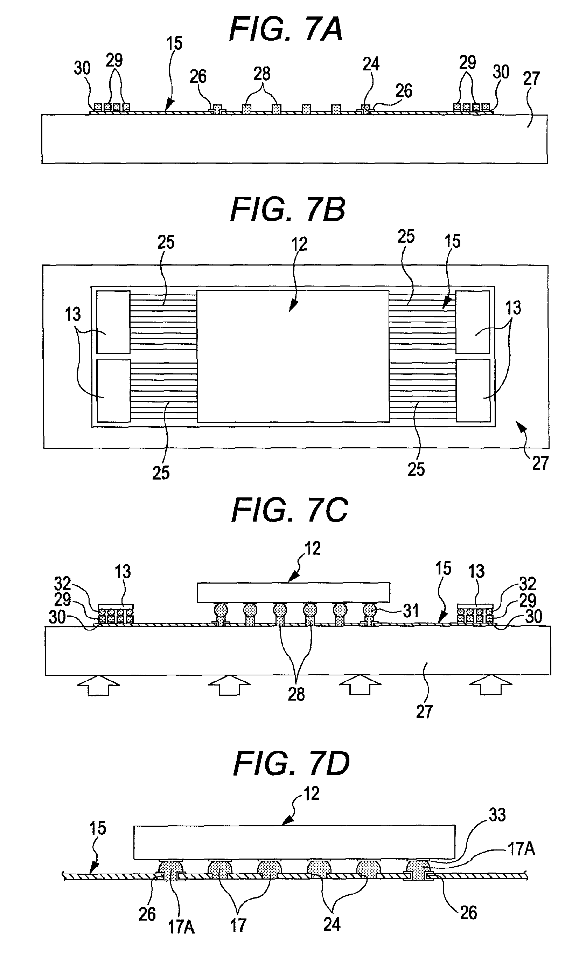

Next, the flexible printed circuit board 15 as depicted in Figs. 7A-7D is described. The flexible printed circuit board 15 is obtained by forming a predetermined wiring pattern 25, a through-hole electrode 26 and the like on a resin film having insulation properties and flexibility (such as polyimide). As depicted in Fig. 7B, the flexible printed circuit board 15 has the BGA type integrated circuit 12 mounted on a substantial center thereof and the two memory devices 13 on both sides thereof in plane view.

The flexible printed circuit board 15 has a fixed portion 15A to be fixed to the printed wiring substrate 11 and extending portions 15B extending outwardly from both sides of the fixed portion 15A. The fixed portion 15A is located on a central portion of the flexible printed circuit board 15 and corresponds to a mounting position at which the BGA type integrated circuit 12 is mounted.

The fixed portion 15A is arranged between the printed wiring substrate 11 and the BGA type integrated circuit 12 when the BGA type integrated circuit 12 is mounted on the printed wiring substrate 11. Also, when the BGA type integrated circuit 12 is mounted on the printed wiring substrate 11, the connection terminal 17 of the BGA type integrated circuit 12 is connected to the substrate electrode 23 of the printed wiring substrate 11, so that the fixed portion 15A is also fixed to the printed wiring substrate 11 at the same time.

A specific structure in which the fixed portion 15A of the flexible printed circuit board 15 is fixed to the printed wiring substrate 11 is described with reference to Fig. 5. The fixed portion 15A has a through-hole 24 at a position corresponding to the connection terminal 17 provided on the BGA type integrated circuit 12. Also, out of a plurality of through-holes 24 formed, the through-hole 24 which corresponds to the connection terminal 17 connected to the memory device 13, electrically connects the connection terminal 17 to the wiring pattern 25, so that this is made the through-hole electrode 26. Meanwhile, in a following description, the connection terminal connected to the through-hole electrode 26 is especially referred to as a connection terminal 17A.

The connection terminal 17 formed on the BGA type integrated circuit 12 is fixed by means of soldering to the substrate electrode 23 of the printed wiring substrate 11 through the through-hole 24 and the through-hole electrode 26 formed on the fixed portion 15A. When the connection terminal 17 melted by soldering is cooled to be solidified, the connection terminal 17 joins to the substrate electrode 23 and holds the fixed portion 15A. Because of this, the fixed portion 15A is fixed between the printed wiring substrate 11 and the BGA type integrated circuit 12 when the BGA type integrated circuit 12 is mounted on the printed wiring substrate 11.

When the fixed portion 15A is fixed to the printed wiring substrate 11 as described above, the through-hole electrode 26 is electrically connected to the connection terminal 17A connected to the memory device 13, and to the substrate electrode 23 of the printed wiring substrate 11 corresponding to the connection terminal 17A. Also, the through-hole electrode 26 is connected to the memory device 13 through the wiring pattern 25. Therefore, when the fixed portion 15A is fixed to the printed wiring substrate 11, the memory device 13 is put in a state of being electrically connected to the BGA type integrated circuit 12 and the printed wiring substrate 11.

In this manner, in this embodiment, when the BGA type integrated circuit 12 is soldered to the printed wiring substrate 11, the flexible printed circuit board 15 also is fixed to and electrically connected to the printed wiring substrate 11. Therefore, a process of fixing and connecting the flexible printed circuit board 15 to the printed wiring substrate 11 becomes easy, and a manufacturing process of the semiconductor device unit 10A may be simplified.

On the other hand, the memory device 13 is mounted on a tip end portion of the extending portion 15B sequentially extending from the above-described fixed portion 15A. Specifically, an electrode 30 is formed on the tip end portion of the extending portion 15B, and the memory device 13 is mounted on the extending portion 15B by soldering of a BGA ball 21 of the memory device 13 to the electrode 30.

The electrode 30 is connected to one end of the wiring pattern 25, and the other end of the wiring pattern 25 is pulled out to the through-hole electrode 26. Therefore, the memory device 13 is electrically connected to the printed wiring substrate 11 and the BGA type integrated circuit 12 through the wiring pattern 25 and the through-hole electrode 26 by mounting the memory device 13 on the extending portion 15B.

Also, a bypass capacitor 14 may be arranged close to each of the integrated circuit 12 and/or the memory device 13. In this embodiment, the bypass capacitor 14 is mounted on a surface opposite to a surface on which the memory device 13 of the extending portion 15 is mounted.

The flexible printed circuit board 15 thus configured is bent on the printed wiring substrate 11 toward the BGA type integrated circuit 12. In detail, the flexible printed circuit board 15 is such that the extending portion 15B is bent relative to the fixed portion 15A toward the BGA type integrated circuit 12. The extending portion 15B may form a substantially right angle with the printed wiring substrate 11.

In this manner, by bending the extending portion 15B relative to the fixed portion 15A to form the substantially right angle therebetween so as to be close to the BGA type integrated circuit 12, the memory device 13 is put in a state of being extremely close to the BGA type integrated circuit 12. In this embodiment, the memory device 13 is fixed to the radiating fin 18 attached to the BGA type integrated circuit 12 using an adhesive 20. Meanwhile, in a following description, the BGA type integrated circuit 12 is intended to include the radiating fin 18. The radiating fin may be regarded as heat dissipation member.

In this manner, the memory device 13 may be coupled to a side surface of the BGA type integrated circuit 12. Therefore, a planar area on the printed wiring substrate 11 covered by the BGA type integrated circuit 12, the memory device 13 and the flexible printed circuit board 15 may be made smaller (refer to Fig. 4). Also, although the flexible printed circuit board 15 is flexible and has the structure in which the extending portion 15B extends to form a shape of a cantilever, the memory device 13 mounted on the extending portion 15B is fixed to the BGA type integrated circuit 12, so that the memory device 13 and the extending portion 15B may be stably held.

As described above, the semiconductor device unit 10A may be mounted on electronic devices for performing high-speed signal processes such as a server. A signal speed between the BGA type integrated circuit 12 and the memory device 13 and the signal speed between adjacent BGA type integrated circuits 12 in the semiconductor device unit 10A of this embodiment will be described.

In this embodiment, the memory device 13 is electrically connected to the printed wiring substrate 11 and the BGA type integrated circuit 12 using the flexible printed circuit board 15. Also, the number of terminals of the memory device 13 and that of the bypass capacitor 14 mounted on the flexible printed circuit board 15 are smaller than that of the BGA type integrated circuit 12. Therefore, a pattern shape of the wiring pattern 25 formed on the flexible printed circuit board 15 may be made substantially linear as depicted in Fig. 7B.

Also, other than the memory device 13, only the bypass capacitor 14 is mounted on the flexible printed circuit board 15. Therefore, length of the extending portion 15B may be optionally set without being affected by a component mounted on the printed wiring substrate 11 (such as the electronic component 16), so that the length of the extending portion 15B may be set short.

Therefore, the length of the wiring pattern 25 extending from the through-hole electrode 26 formed on the flexible printed circuit board 15 to the memory device 13 may be made shorter than that in a conventional configuration. Therefore, the high-speed signal between the BGA type integrated circuit 12 and the memory device 13 is prevented from deteriorating, so that reliability of the semiconductor device unit 10A may be improved.

Also, in this embodiment, the memory device 13 is not mounted on the printed wiring substrate 11 but is fixed to the side surface of the BGA type integrated circuit 12. In this manner, since the memory device 13 is not mounted on the printed wiring substrate 11 in this embodiment, the adjacent BGA type integrated circuits 12 may be made close to each other.

In this manner, in this embodiment, a distance between the adj acent BGA type integrated circuits 12 may be made shorter than before. Therefore, the high-speed signal between the adjacent BGA type integrated circuits 12 may be prevented from deteriorating and the reliability of the semiconductor device unit 10A may be improved. Meanwhile, in Fig. 4, a thin solid line indicates an example of a signal transmission pathway between the BGA type integrated circuit 12 and the memory device 13, and a bold solid line indicates an example of the signal transmission pathway between the BGA type integrated circuits 12 and between the BGA type integrated circuit 12 and the electronic component 16.

Also, as described above, the semiconductor device unit 10A according to this embodiment is capable of allowing the adjacent BGA type integrated circuits 12 to be close to each other on the printed wiring substrate 11. Therefore, the printed wiring substrate 11 may be made smaller, and consequently, the semiconductor device unit 10A may be made smaller.

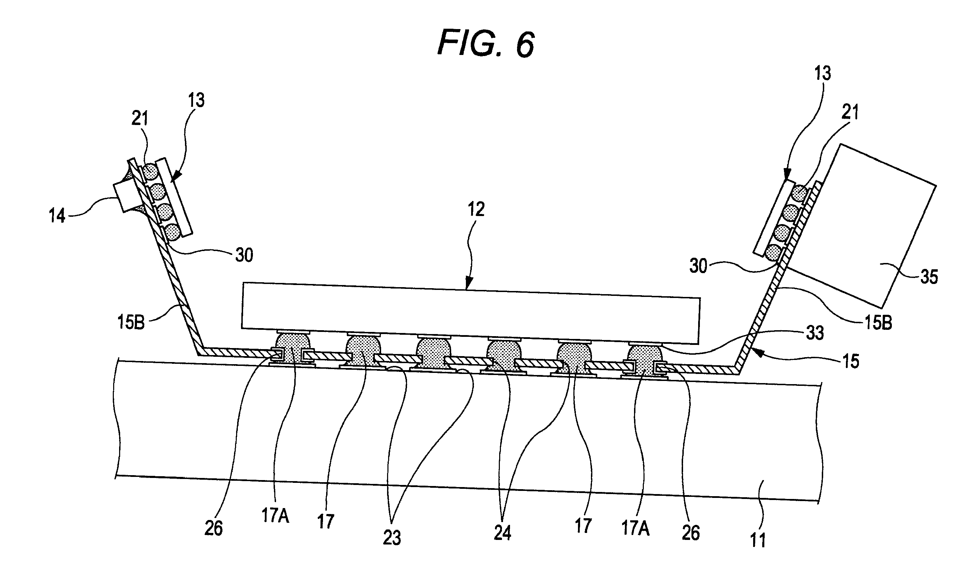

Fig. 6 illustrates a state in which a repair process is performed in the semiconductor device unit 10A. In this drawing, an example in which the memory device 13 located on a right side of the drawing is a defective product and is repaired is depicted.

In order to detach the memory device 13 from the flexible printed circuit board 15, first, the memory device 13 is detached from the radiating fin 18, subsequently, the radiating fin 18 is detached from the BGA type integrated circuit 12, and further, the bypass capacitor 14 is detached from the flexible printed circuit board 15. Then, a heating jig 35 is pressed against a rear surface side of the flexible printed circuit board 15 (extending portion 15B) to melt the BGA ball 21.

Because of this, the memory device 13 is detached from the flexible printed circuit board 15. Then, after the memory device 13 being the defective product is detached, the memory device 13 being a non-defective product is mounted on the flexible printed circuit board 15 (extending portion 15B) using the heating jig 35.

At the time of the repair process, a heating process is performed to the flexible printed circuit board 15, and the heating process is not performed to the printed wiring substrate 11. Also the flexible printed circuit board 15 may be separated from the BGA type integrated circuit 12 by moving (bending) the flexible printed circuit board 15 in a direction separating from the BGA type integrated circuit 12.

Therefore, even when the memory device 13 is arranged to be fixed to the BGA type integrated circuit 12, the memory device 13 may be separated from the BGA type integrated circuit 12 at the time of the repair, so that it is possible to prevent the heat applied to the memory device 13 at the time of the repair from affecting the BGA type integrated circuit 12. Therefore, high-density mounting and improved repair properties of each of the BGAs 12 and 13 of the semiconductor device unit 10A may be realized together.

Next, a method of manufacturing the semiconductor device unit 10A according to the first embodiment is described. Figs. 7A to 8D illustrate one embodiment of the method of manufacturing the semiconductor device unit 10A.

In order to manufacture the semiconductor device unit 10A, the flexible printed circuit board 15 is mounted on a ceramic substrate 27, as depicted in Fig. 7A. On the flexible printed circuit board 15, the through-hole 24 and the through-hole electrode 26 are formed in advance at positions corresponding to arranging positions of the connection terminals 17 of the BGA type integrated circuit 12. Also, the electrode 30 is formed at a mounting position of the memory device 13. Meanwhile, the substrate on which the flexible printed circuit board 15 is mounted is not limited to the ceramic substrate 27, and another substrate (a metal substrate, for example) may be used.

A soldering paste 28 is arranged on the substrate electrode 23 formed on the flexible printed circuit board 15, and also, a soldering paste 29 is arranged on the electrode 30. A screen printing method may be used to arrange the soldering pastes 28 and 29.

When the soldering pastes 28 and 29 are arranged on the flexible printed circuit board 15 as described above, the BGA type integrated circuit 12 is temporarily fixed on the soldering paste 28 and the memory device 13 is temporarily fixed on the soldering paste 29. Fig. 7B is a plane view of the flexible printed circuit board 15 on which each of the BGAs 12 and 13 are temporarily fixed, and FIG. 7C is a front view of the flexible printed circuit board 15 on which each of the BGAs 12 and 13 are temporarily fixed.

When each of the BGAs 12 and 13 are temporarily fixed on the flexible printed circuit board 15 as described above, the flexible printed circuit board 15 is mounted on a reflow furnace together with the ceramic substrate 27, and the heating process is performed. Because of this, a soldering ball 31 arranged on the BGA type integrated circuit 12 and the soldering paste 28 are melted to be integrated with each other and form the connection terminals 17 and 17A, which pass through the through-hole 24 formed on the flexible printed circuit board 15. Also, a soldering ball 32 of the memory device 13 and the soldering paste 29 are melted to be integrated with each other and are soldered to the electrode 30.

Subsequently, the flexible printed circuit board 15 is peeled from the ceramic substrate 27. Fig. 7D illustrates the vicinity of the connection terminals 17 and 17A of the flexible printed circuit board 15 peeled from the ceramic substrate 27 in an enlarged manner. As depicted therein, the connection terminals 17 and 17A are solidified in a state of passing through the through-holes 24, and therefore the fixed portion 15A of the flexible printed circuit board 15 is in a state of being fixed to the BGA type integrated circuit 12 through the connection terminals 17 and 17A. Also, in the peeled state, the extending portion 15B is in a state of extending in a horizontal direction. Meanwhile, when mounting the bypass capacitor 14, this is mounted after the peeling.

Subsequently, a bending process is performed to the flexible printed circuit board 15. The bending process is a process of bending the extending portion 15B relative to the fixed portion 15A toward the BGA type integrated circuit 12.

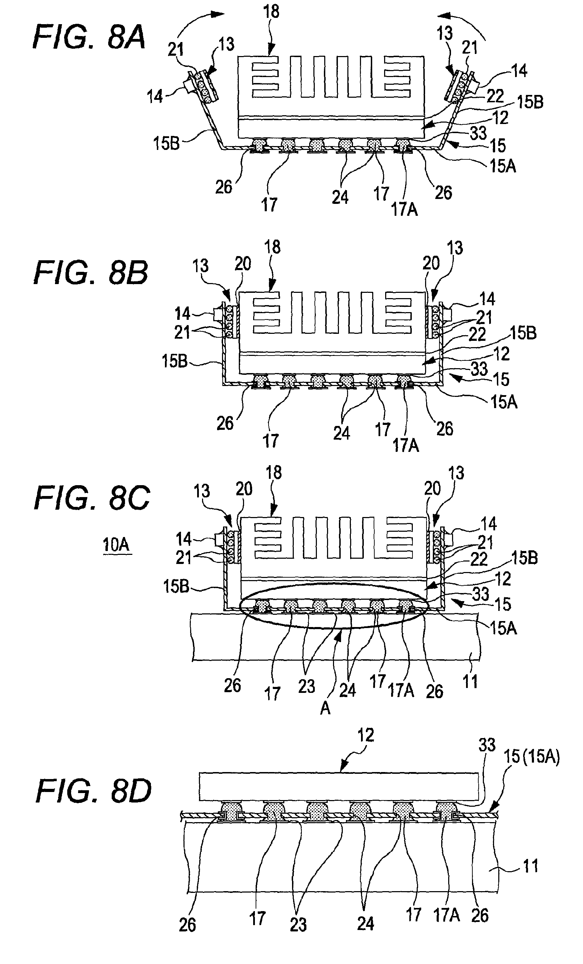

Fig. 8A shows a state in which the extending portion 15B is bent toward the BGA type integrated circuit 12.

As described above, in this embodiment, since the memory device 13 is fixed to the BGA type integrated circuit 12, the adhesive 20 is applied to the surface fixed to the BGA type integrated circuit 12 of the memory device 13. Then, the memory device 13 is bonded to be fixed to the radiating fin 18 by means of the adhesive 20. Fig. 8B shows a state in which the memory device 13 is fixed to the radiating fin 18. As depicted in the drawing, in a state in which the memory device 13 is fixed to the radiating fin 18, the flexible printed circuit board 15 is in a form such that the extending portion 15B is bent relative to the fixed portion 15A to form the substantially right angle therebetween.

In this manner, the process of allowing the memory device 13 to be closely positioned to the BGA type integrated circuit 12 may be performed by bending the flexible printed circuit board 15 and bonding the memory device 13 to the radiating fin 18 using the adhesive 20.

As described above, when the memory device 13 and the flexible printed circuit board 15 are mounted on the BGA type integrated circuit 12, the BGA type integrated circuit 12 is mounted on the printed wiring substrate 11. On the printed wiring substrate 11, the substrate electrodes 23 are formed at the positions corresponding to the connection terminals 17 and 17A, in advance. A soldering paste not shown is applied to the substrate electrode 23 in advance. Also, the connection terminals 17 and 17A are in a state of being exposed from the through-holes 24 on the rear surface side (side opposed to the printed wiring substrate 11) of the flexible printed circuit board 15.

In order to mount the BGA type integrated circuit 12 on the printed wiring substrate 11, the substrate electrodes 23 and the connection terminals 17 and 17A are positioned, and the substrate electrodes 23 and the connection terminals 17 and 17A are temporarily fixed by soldering paste. Subsequently, the heating process is performed to the printed wiring substrate 11 on which the BGA type integrated circuit 12 is temporarily fixed in a reflow furnace.

The connection terminal 17 and the soldering paste on the substrate electrode 23 are thereby melted to be integrated with each other, the BGA type integrated circuit 12 is soldered to the substrate electrode 23, and the BGA type integrated circuit 12 is mounted on the printed wiring substrate 11. Also, by the soldering process, the fixed portion 15A of the flexible printed circuit board 15 is put in a state of being fixed between the BGA type integrated circuit 12 and the printed wiring substrate 11. As such, the flexible printed circuit board 15 is also put in a state of being fixed to the printed wiring substrate 11.

By the above-described series of processes, the BGA type integrated circuit 12 is mounted on the printed wiring substrate 11 and the memory device 13 is mounted on the printed wiring substrate 11 through the flexible printed circuit board 15 and the BGA type integrated circuit 12. Fig. 8C shows a state in which the BGA type integrated circuit 12 is mounted on the printed wiring substrate 11, and Fig. 8D shows the vicinity of the connection terminals 17 and 17A indicated by an arrow A in Fig. 8C in an enlarged manner.

In this manner, even when it is configured to arrange the fixed portion 15A of the flexible printed circuit board 15 between the printed wiring substrate 11 and the BGA type integrated circuit 12, by forming the connection terminals 17 and 17A so as to pass through the through-holes 24 (including the through-hole electrode 26) formed on the fixed portion 15A, the BGA type integrated circuit 12 may be mounted on the printed wiring substrate 11 with a mounting process similar to that of a general BGA type semiconductor device.

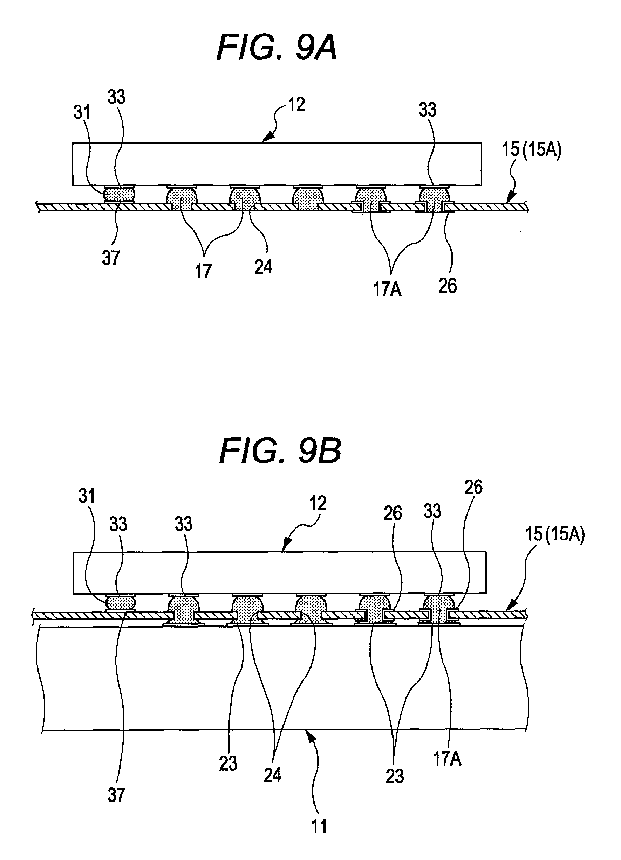

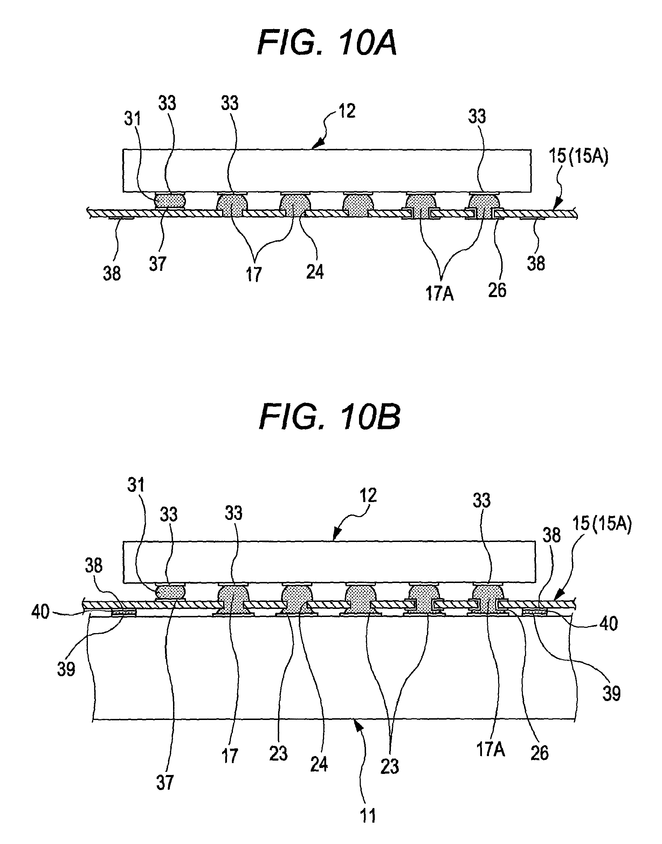

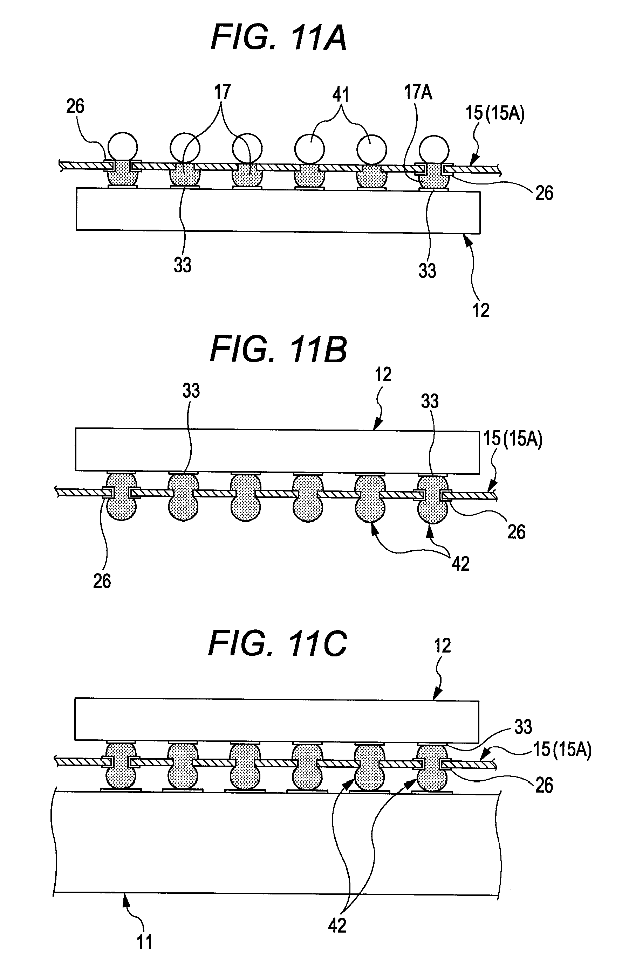

Next, a modified example of the above-described embodiment of the semiconductor device unit 10A and the method of manufacturing the same is described. Fig. 9 depicts a first modified example, Fig. 10 depicts a second modified example, and Fig. 11 depicts a third modified example. Meanwhile, in Figs. 9 to 11, the same reference numeral is given to the configuration corresponding to the configuration shown in Figs. 3 to 8, and the description thereof is not repeated here. Also, in each drawing, the vicinity of the fixed portion 15A of the flexible printed circuit board 15 is shown in an enlarged manner.

First, the first modified example illustrated in Fig. 9 is described. In the above-described first embodiment all the connection terminals 17 and 17A provided on the BGA type integrated circuit 12 pass through the through-holes 24 or the through-hole electrodes 26 formed on the flexible printed circuit board 15 (fixed portion 15A). On the other hand, in this modified example, not all the device side electrodes 33 provided on the substrate electrodes 23 are connected to the printed wiring substrate 11, but a part of the device side electrodes 33 is connected only to the flexible printed circuit board 15.

Specifically, as depicted in Fig. 9A, the through-hole 24 is not formed at the position corresponding to the device side electrode 33 located on a left end of the drawing of the flexible printed circuit board 15, and in place of this, a flexible printed circuit board electrode 37 (hereinafter, referred to as a FPC electrode 37) is formed. The FPC electrode 37 is electrically connected to the wiring pattern 25 formed on the flexible printed circuit board 15. Also, the device side electrode 33 and the FPC electrode 37 are electrically connected by means of the soldering ball 31.

Therefore, as depicted in Fig. 9B, in a state in which the BGA type integrated circuit 12 is mounted on the printed wiring substrate 11, although other connection terminals 17 and 17A are connected to the substrate electrodes 23 of the printed wiring substrate 11, the soldering ball 31 is connected only to the FPC electrode 37. In a case in which the device side electrode 33, which is not required to be connected to the printed wiring substrate 11, exists as in this embodiment, this may be configured to be electrically connected only to the flexible printed circuit board 15 without forming the through-hole 24 on the flexible printed circuit board 15.

Next, the second modified example illustrated in Figs. 10A and 10B is described. In this modified example, as depicted in Fig. 10A, a reinforcing electrode 38 is formed at an outer peripheral position of the fixed portion 15A. The reinforcing electrode 38 is formed on a surface on a side opposed to the printed wiring substrate 11 of the flexible printed circuit board 15 as illustrated in Fig. 10B. Also, the reinforcing electrode 38 is formed of a metallic material capable of being soldered as in the case of the above-described electrode 30. Although the electrode 30 is connected to the wiring pattern 25, the electrode 30 is not required to be necessarily connected with the wiring pattern 25.

Also, a reinforcing electrode 39 is formed at a position corresponding to a forming position of the reinforcing electrode 38 of the printed wiring substrate 11. The reinforcing electrode 39 is formed together at the same time when forming the substrate electrode 23.

When the first printed substrate is mounted on the printed wiring substrate 11, the reinforcing electrode 38 formed on the fixed portion 15A is soldered to the reinforcing electrode 39 of the printed wiring substrate 11 using a reinforcing solder 40. Therefore, strength of a soldering position of the reinforcing electrode 38 and the reinforcing electrode 39 becomes high, and the soldering position acts as a reinforcing portion to reinforce the soldering position between the connection terminals 17 and 17A and the substrate electrodes 23. It is desirable that a plurality of the reinforcing electrodes 38 and the reinforcing electrodes 39 are formed so as to enclose the soldering positions of the connection terminals 17 and 17A and the substrate electrodes 23.

By soldering the reinforcing electrode 38 and the reinforcing electrode 39 by the reinforcing solder 40, and thereby reinforcing the soldering position of the connection terminals 17 and 17A and the substrate electrodes 23 as described above, it is possible to prevent the connection terminals 17 and 17A and the substrate electrodes 23 from peeling from each other. Therefore, according to this modified example, the reliability of the semiconductor device unit may be improved.

Next, the third modified example illustrated in Figs. 11A-11C is described. In the method of manufacturing according to the above-described embodiment, as depicted in Fig. 7D, when peeling the flexible printed circuit board 15 from the ceramic substrate 27, the portions of the connection terminals 17 and 17A exposed from the through-holes 24 of the flexible printed circuit board 15 are substantially flush with the rear surface of the flexible printed circuit board 15.

However, with the structure in which the connection terminals 17 and 17A are substantially flush with the rear surface of the flexible printed circuit board 15, if there is distortion or the like in the printed wiring substrate 11 when mounting the BGA type integrated circuit 12 illustrated in Fig. 8C, on the printed wiring substrate 11, it is possible that the connection terminals 17 and 17A and the substrate electrodes 23 are not properly connected.

In this modified example, as depicted in Fig. 11A, a process of arranging a soldering ball 41 on the connection terminals 17 and 17A exposed from the through-hole 24 of the flexible printed circuit board 15 after peeling the flexible printed circuit board 15 from the ceramic substrate 27 is provided. A specific arranging method is as follows.

First, the soldering paste is applied in advance to the connection terminals 17 and 17A exposed from the through-holes 24 to temporarily fix the soldering ball 41 on the soldering paste. Because of this, a structure in which the soldering ball 41 is stacked on the connection terminals 17 and 17A is obtained.

Subsequently, the flexible printed circuit board 15 on which the soldering ball 41 is temporarily fixed is mounted in a reflow furnace and a heating process is performed. By performing the reflow process, the soldering ball 41 and the connection terminals 17 and 17A are melted to be integrated with each other, and a stacked connection electrode 42 is formed as depicted in Fig. 11B. As described above, the connection terminals 17 and 17A are formed of the soldering ball 31. Therefore, the stacked connection electrode 42 has a structure in which the soldering ball 31 and the soldering ball 41 are stacked.

The stacked connection electrode 42 has a portion protruded on the rear surface side of the flexible printed circuit board 15. Therefore, as depicted in Fig. 11C, even if the distortion or the like occurs on the printed wiring substrate 11 when mounting the first printed substrate on the printed wiring substrate 11, the stacked connection electrode 42 may be surely soldered to the substrate electrode 23 of the printed wiring substrate 11. Therefore, according to this modified example, mountability of the BGA type integrated circuit 12 to the printed wiring substrate 11 may be improved, and the reliability of the semiconductor device unit may be improved.

Meanwhile, although the example in which one soldering ball 41 is stacked on the connection terminals 17 and 17A is shown in the above-described modified example, the number of soldering balls to be stacked on the connection terminals 17 and 17A is not limited to one, and a configuration in which two or more balls are stacked is possible.

Next, a semiconductor device unit 10B being a second embodiment is described.

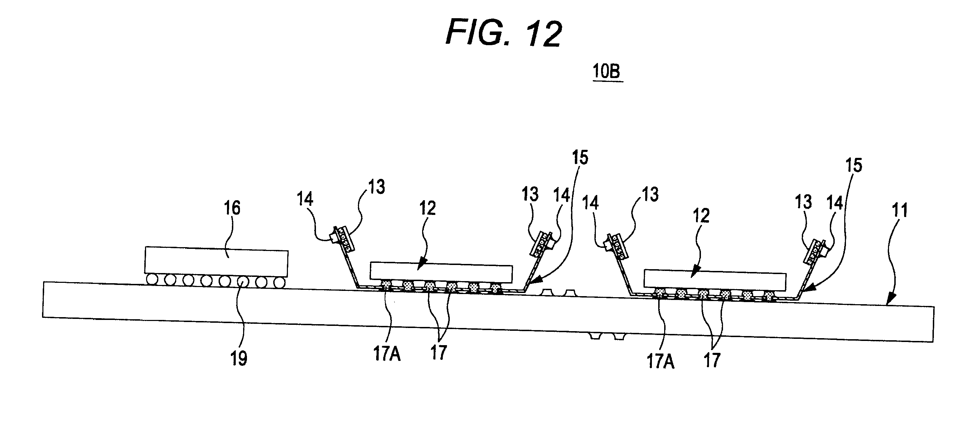

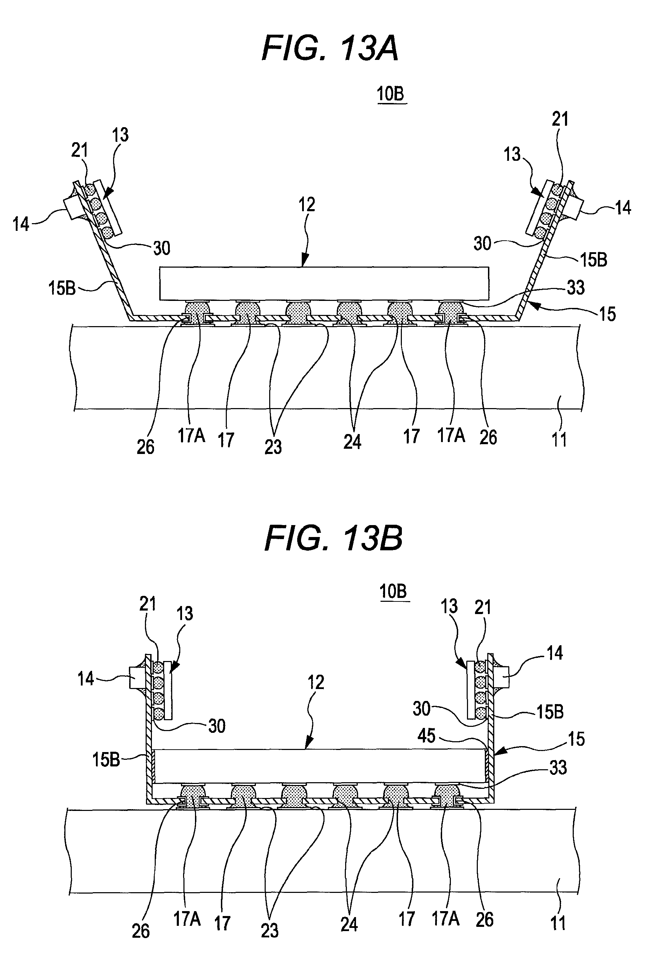

Figs. 12, 13A and 13B are views illustrating the semiconductor device unit 10B. Fig. 12 is a front view of the semiconductor device unit 10B and Fig. 13A is an enlarged view of one BGA type integrated circuit 12 mounted on the printed wiring substrate 11. Meanwhile, in Figs. 12 and 13, the same reference numeral is given to the configuration corresponding to the configuration shown in Figs. 3 to 11, and the description thereof is not repeated here.

In the semiconductor device unit 10A according to the above-described first embodiment shown in Figs. 3 to 5, the BGA type integrated circuit 12 is bonded to the radiating fin 18, and the memory device 13 bonded to the side surface of the radiating fin 18. On the other hand, the BGA type integrated circuit 12 provided on the semiconductor device unit 10B according to this embodiment does not have the radiating fin 18. Therefore, in the semiconductor device unit 10B according to this embodiment, the memory device 13 is held by stiffness of the flexible printed circuit board 15 without fixing the memory device 13 to the radiating fin 18.

Specifically, as depicted in Fig. 13A, the extending portion 15B is bent relative to the fixed portion 15A toward the BGA type integrated circuit 12, and has a structure in which this is extended in a direction to form substantially 45 degree

angles with the printed wiring substrate 11 and is held in the air. The flexible printed circuit board 15 used in this embodiment has a structure capable of holding a bending state when being bent. The flexible printed circuit board 15 having such properties may be realized by installation of a plastically deforming metal wire in a resin base composing the flexible printed circuit board 15 and the like.

Even when the BGA type integrated circuit 12 does not have the radiating fin 18 as in this embodiment, the memory device 13 may be placed at an optional position close to the BGA type integrated circuit 12 by bending the flexible printed circuit board 15 and appropriately setting an angle between the extending portion 15B and the printed wiring substrate 11. Also, as depicted in Fig. 13B, a configuration in which the extending portion 15B is fixed to the side surface of the BGA type integrated circuit 12 using an adhesive 45 in place of the radiating fin 18 is possible. Further, it is also possible to bend the flexible printed circuit board 15 such that a part of the extending portion 15B opposes the upper surface of the BGA type integrated circuit 12 to obtain a structure in which the memory device 13 is fixed to the upper surface of the BGA type integrated circuit 12.

Next, a semiconductor device unit 10C being a third embodiment is described.

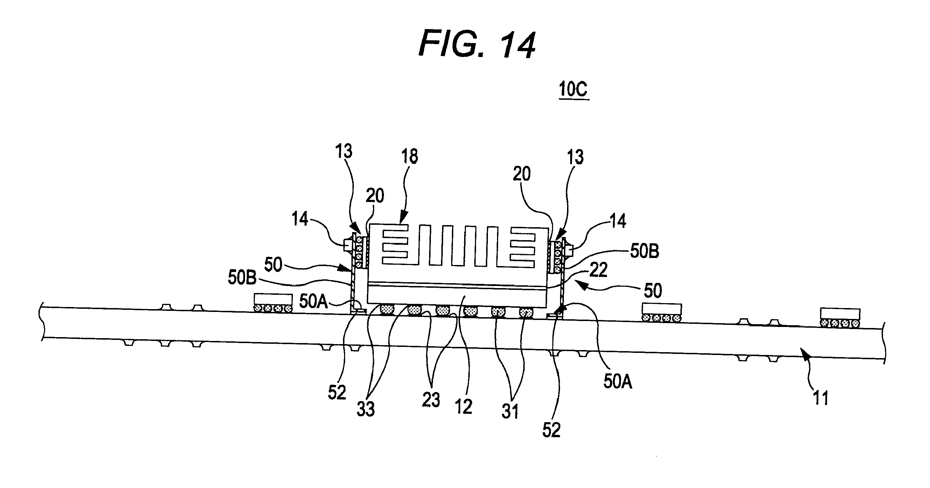

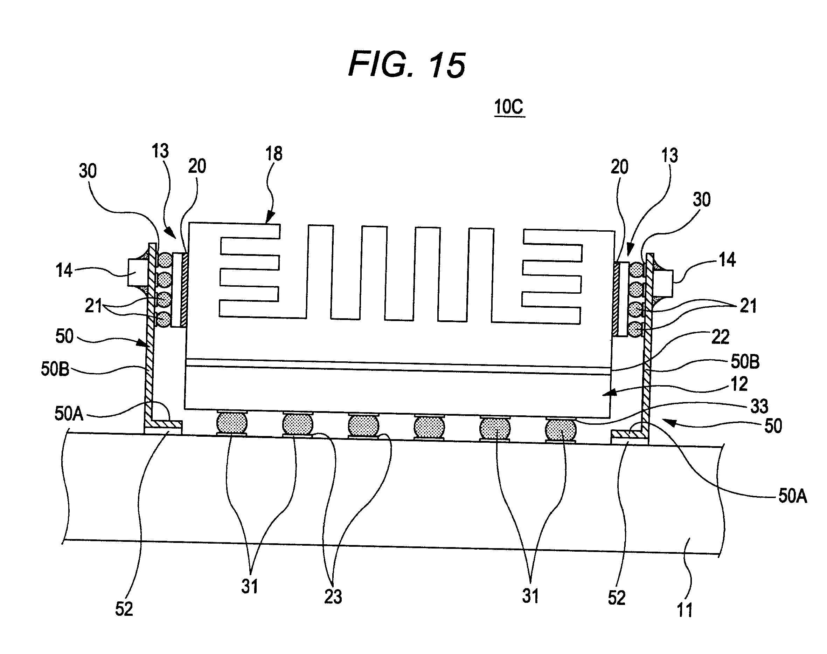

Figs. 14 and 15 are views illustrating the semiconductor device unit 10C. Fig. 14 is a front view of the semiconductor device unit 10C and Fig. 15 is an enlarged view of one BGA type integrated circuit 12 mounted on the printed wiring substrate 11. In Figs. 14 and 15, the same reference numeral is given to a configuration corresponding to the configuration shown in Figs. 3 to 11, and the description thereof is not repeated here.

The semiconductor device units 10A and 10B according to the above-described first and second embodiments, respectively, have the structure in which the fixed portion 15A of the flexible printed circuit board 15 opposes to the rear surface of the BGA type integrated circuit 12. On the other hand, the semiconductor device unit 10C according to this embodiment is configured such that a connection fixing electrode 52 is formed on an outer side of the mounting position at which the BGA type integrated circuit 12 of the printed wiring substrate 11 is mounted, and a fixed portion 50A of a flexible printed circuit board 50 is connected to the connection fixing electrode 52.

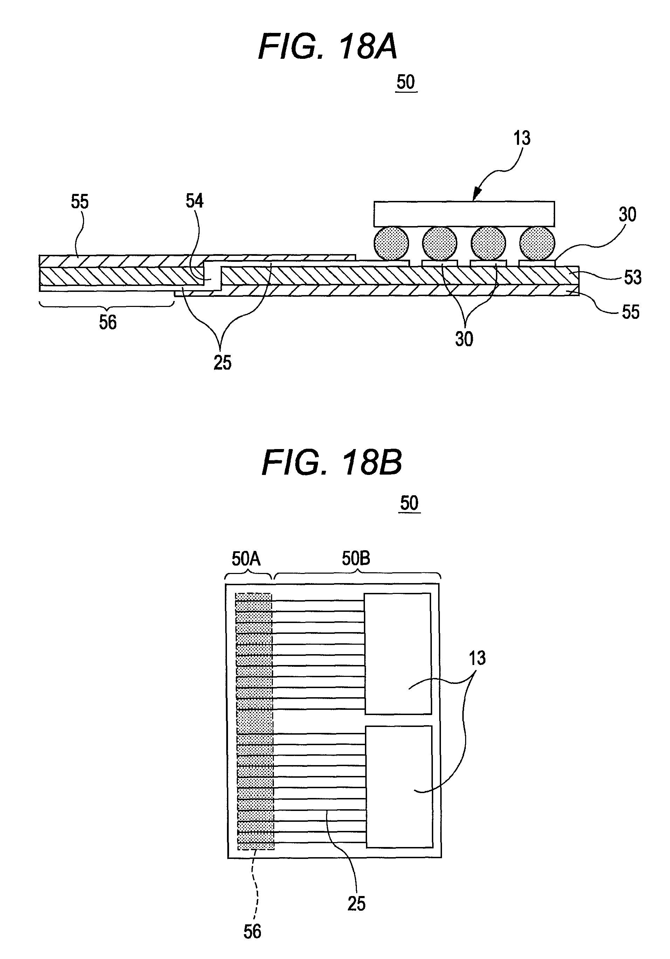

Figs. 18A and 18B illustrate the flexible printed circuit board 50 used in the semiconductor device unit 10C. The flexible printed circuit board 15 used in the semiconductor device units 10A and 10B according to the first and second embodiments, respectively, have the structure in which the extending portions 15B extend outwardly from both sides of the fixed portion 15A, which opposes the BGA type integrated circuit 12, as depicted in Fig. 7B. On the other hand, the fixed portion 50A of the flexible printed circuit board 50 has a length sufficient to be connected to the connection fixing electrode 52. Therefore, the fixed portion 50A is shorter than the fixed portion 15A shown in the first and second embodiments. Also,

the extending portion 50B has a structure extending outwardly only from one side portion of the fixed portion 50A.

The connection fixing electrode 52 is the electrode equivalent to the substrate electrode 23, and is formed together when forming the substrate electrode 23. Also, the connection fixing electrode 52 is connected to the wiring layer formed in the printed wiring substrate 11, and is connected to the connection terminal 31 connected to the memory device 13 through the wiring layer. Therefore, the memory device 13 mounted on the flexible printed circuit board 50 is electrically connected to the BGA type integrated circuit 12 through the connection terminal 31, the substrate electrode 23, the wiring layer in the printed wiring substrate 11, the connection fixing electrode 52 and the flexible printed circuit board 50.

The flexible printed circuit board 50 in which the fixed portion 50A is connected (fixed) to the connection fixing electrode 52 is bent on the printed wiring substrate 11 toward the BGA type integrated circuit 12. Also, the extending portion 50B forms a substantially right angle with the printed wiring substrate 11. Then, as in the case of the first embodiment, the memory device 13 is fixed to the BGA type integrated circuit 12 (radiating fin 18) using the adhesive 20.

In this manner, by bending the extending portion 50B relative to the fixed portion 50A to form the substantially right angle therebetween so as to be close to the BGA type integrated circuit 12, the memory device 13 is put in a state extremely close to the BGA type integrated circuit 12. Therefore, in this embodiment also, the planar area on the printed wiring substrate 11 covered by the BGA type integrated circuit 12, the memory device 13 and the flexible printed circuit board 50 becomes smaller, and it becomes possible to obtain a smaller printed wiring substrate 11 and a smaller semiconductor device unit 10C.

In this embodiment also, as in the case of the semiconductor device unit 10A according to the first embodiment, a length of wiring extending from the BGA type integrated circuit 12 to the memory device 13 may be made shorter than before, therefore, the high-speed signal between the BGA type integrated circuit 12 and the memory device 13 is prevented from deteriorating. Further, in the semiconductor device unit 10C, the distance between the adjacent BGA type integrated circuits 12 may be made shorter, and therefore the high-speed signal between the adjacent BGA type integrated circuits 12 also is prevented from deteriorating.

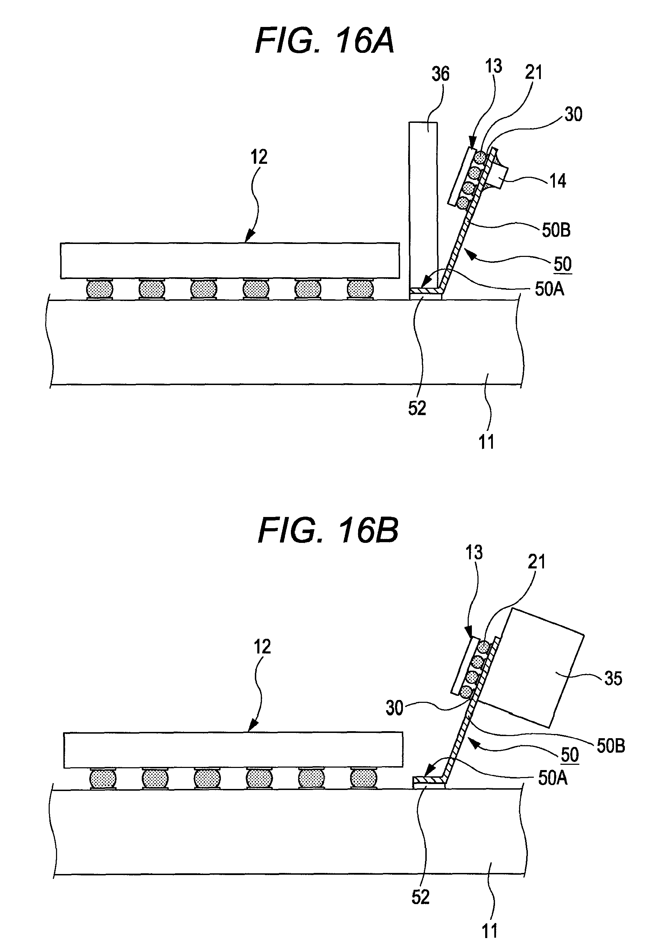

Figs. 16A and 16B depict a state in which the repair process is performed in the semiconductor device unit 10C. An example in which the memory device 13 located on a right side in Fig. 15 is the defective product and is repaired is illustrated.

Fig. 16A depicts an example in which the memory device 13 is repaired together with the flexible printed circuit board 50. Herein, a case in which the fixed portion 50A and the connection fixing electrode 52 are soldered is described. In order to detach the flexible printed circuit board 50 from the printed wiring substrate 11, a joining position of the fixed portion 50A and the connection fixing electrode 52 is heated using a heating jig 36. Thereby, the solder, which joins the fixed portion 50A and the connection fixing electrode 52, is melted, and the flexible printed circuit board 50 is detached from the connection fixing electrode 52. Also, the flexible printed circuit board 50 on which the memory device 13 being the non-defective product is mounted also is soldered to the connection fixing electrode 52 using the heating jig 36.

At the time of this repair, the heating jig 36 may detach or solder the flexible printed circuit board 50 from or to the connection fixing electrode 52 by heating only the joining position of the fixed portion 50A and the connection fixing electrode 52. Therefore, an area to be heated at the time of the repair may be made narrower than that in conventional processes. As such, even when the electronic components are mounted in the vicinity of the BGA type integrated circuit 12 on the printed wiring substrate 11, it is possible to detach or solder the flexible printed circuit board 50 from or to the printed wiring substrate 11 without affecting the electronic components by the heat.

On the other hand, the method shown in Fig. 16B is the same method as the repair performed in the semiconductor device unit 10A of the above-described first embodiment. That is to say, in order to detach the memory device 13 from the flexible printed circuit board 50, the heating jig 35 is pressed against the rear surface side of the flexible printed circuit board 50 (extending portion 50B) to melt the BGA ball 21. Because of this, the memory device 13 is detached from the flexible printed circuit board 50. After the detachment of the defective memory device 13, the non-defective memory device 13 is mounted on the flexible printed circuit board 50 using the heating jig 35.

Next, the method of manufacturing the semiconductor device unit 10C according to the third embodiment is described.

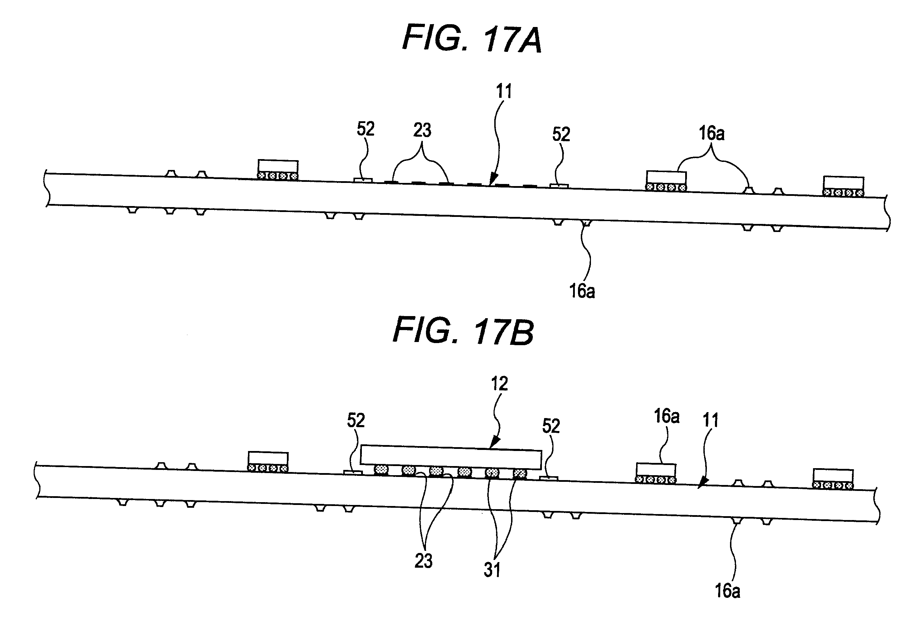

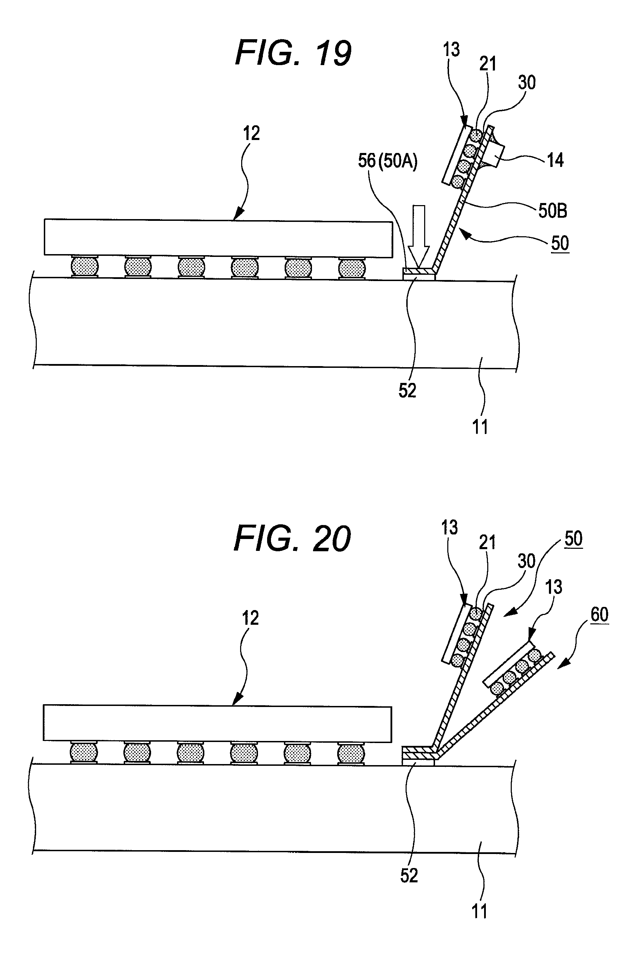

Figs. 17A, 17B and 19 show one embodiment of the method of manufacturing the semiconductor device unit 10C. Meanwhile, the radiating fin 18 is not shown in each drawing.

In order to manufacture the semiconductor device unit 10C, the printed wiring substrate 11 shown in Fig. 17A is prepared. On the printed wiring substrate 11, the substrate electrode 23 is formed at the position at which the BGA type integrated circuit 12 is mounted and the position corresponding to the arranging position of the connection terminal 31. Also, on the printed wiring substrate 11, the connection fixing electrode 52 is formed on the outer side of the mounting position of the BGA type integrated circuit 12. The connection fixing electrode 52 is formed at the same time when forming the substrate electrodes 23 as described above.

The soldering paste is applied to the upper portion of the substrate electrode 23 formed on the printed wiring substrate 11. Next, the BGA type integrated circuit 12 is mounted on the substrate electrode 23 and the connection terminal 31 is temporarily fixed by means of the soldering paste. Subsequently, the printed wiring substrate 11 on which the BGA type integrated circuit 12 is temporarily fixed is mounted on the reflow furnace and the heating process is performed. Thereby, the connection terminal 31 and the soldering paste are melted, and the BGA type integrated circuit 12 is soldered to the substrate electrode 23. Fig. 17B shows a state in which the BGA type integrated circuit 12 is mounted on the printed wiring substrate 11.

Meanwhile, an electronic component 16a mounted on the printed wiring substrate 11 together with the BGA type integrated circuit 12 is soldered to the printed wiring substrate 11 at the same time of the reflow process.

On the other hand, a manufacturing process of the flexible printed circuit board 50 is performed with a process other than the mounting process of the BGA type integrated circuit 12 on the printed wiring substrate 11. Figs. 18A and 18B depict the flexible printed circuit board 50 in an enlarged manner. As depicted in the drawing, in the flexible printed circuit board 50, the wiring pattern 25 is formed on an insulating film 53, and a cover layer 55 for insulating the wiring pattern 25 by covering the same is formed.

The cover layer 55 is removed at the mounting position of the memory device 13 and a connecting position with the connection fixing electrode 52, and the wiring pattern 25 and the electrode 30 are exposed. Further, the wiring patterns 25 formed on an upper side and a lower side on the drawing of the insulating film 53 are connected by a via 54, which passes through the insulating film 53. Meanwhile, in a following

description, the connecting position of the flexible printed circuit board 50 and the connection fixing electrode 52 is referred to as a connecting portion 56.

The memory device 13 is mounted on the flexible printed circuit board 50 before connecting the flexible printed circuit board 50 to the printed wiring substrate 11. Specifically, the memory device 13 is temporarily fixed to the electrode 30 to which the soldering paste is applied in advance, and is mounted on the flexible printed circuit board 50 by performing the reflow process thereto. Figs. 18A and 18B illustrate a state in which the memory device 13 is mounted on the flexible printed circuit board 50.

The flexible printed circuit board 50 on which the memory device 13 is mounted is connected to the connection fixing electrode 52 of the printed wiring substrate 11 on which the BGA type integrated circuit 12 is mounted. In order to connect the flexible printed circuit board 50 to the printed wiring substrate 11, the connecting portion 56 located on the fixed portion 50A is positioned on the connection fixing electrode 52 to join the connecting portion 56 to the connection fixing electrode 52. As the joining method, a soldering method, a pressure bonding method, an anisotropic conductive film (ACF) connecting method and the like may be used. Fig. 19 shows a state in which the connecting portion 56 (fixed portion 50A) is joined to the connection fixing electrode 52.

Subsequently, the bending process is performed to the flexible printed circuit board 50. The bending process is the process of bending the extending portion 50B relative to the fixed portion 50A toward the BGA type integrated circuit 12. As described above, in this embodiment also, the memory device 13 is fixed to the BGA type integrated circuit 12 (radiating fin 18). As depicted in Fig. 15, in a state in which the memory device 13 is fixed to the radiating fin 18, in the flexible printed circuit board 50, the extending portion 50B is bent relative to the printed wiring substrate 11 (fixed portion 50A) to form the substantially right angle therebetween.

As described above, in the manufacturing method according to this embodiment, since the fixed portion 50A is not arranged between the printed wiring substrate 11 and the BGA type integrated circuit 12 unlike in the case of the semiconductor device unit 10A according to the first embodiment, the structure of the flexible printed circuit board 50 may be simplified. When connecting the flexible printed circuit board 50 to the printed wiring substrate 11 also, the joining process may be performed only by positioning the connecting portion 56 and the connection fixing electrode 52. Therefore, the manufacturing process of the semiconductor device unit 10C may be simplified.

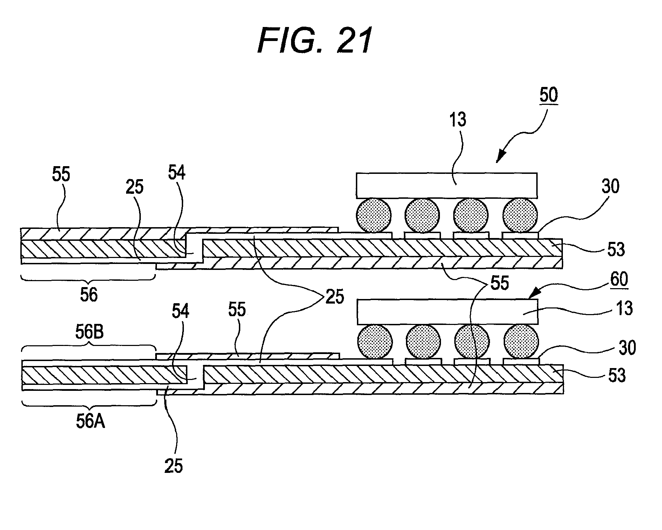

Figs. 20 and 21 show a modified example of the semiconductor device unit 10C being the third embodiment. The semiconductor device unit 10C shown in Figs. 14 and 15 is configured such that only one flexible printed circuit board 50 is connected on the connection fixing electrode 52. On the other hand, in this modified example, a plurality of flexible printed circuit boards 50 and 60 are stacked on the connection fixing electrode 52 and connected, as depicted in Fig. 20. Although the example in which two flexible printed circuit boards 50 and 60 are stacked on the connection fixing electrode 52 is shown in this modified example, the total number of the flexible substrates to be stacked on the connection fixing electrode 52 is not limited to two, and a configuration in which three or more substrates are stacked is possible.

Fig. 21 depicts the flexible printed circuit boards 50 and 60 used in this modified example. The flexible printed circuit board 50 is the flexible substrate located on an uppermost portion. Since the flexible printed circuit board 50 has the same configuration as that of the flexible printed circuit board 50 illustrated in Figs. 18A and 18B, the description thereof is not repeated here.

The flexible substrate 60 is the flexible substrate arranged between the flexible printed circuit board 50 and the connection fixing electrode 52. In the flexible substrate 60, the connecting portion 56A for connecting to the connection fixing electrode 52 is formed on a lower surface thereof, and the connecting portion 56B is also provided on a surface opposite to the connecting portion 56A. The connecting portion 56B is connected to the connecting portion 56 of the flexible printed circuit board 50.

Regarding connecting method of connecting the flexible printed circuit boards 50 and 60 to the connection fixing electrode 52, the above-described soldering method, pressure-bonding method, ACF connecting method and the like may be used. Also, as a procedure to connect the flexible printed circuit boards 50 and 60 to the connection fixing electrode 52, a method of first joining the connecting portion 56A of the flexible substrate 60 to the connection fixing electrode 52 and thereafter joining the connecting portion 56 of the flexible printed circuit board 50 to the connecting portion 56B may be used. Also, it is possible to use a method of positioning the flexible printed circuit boards 50 and 60 in advance such that connecting portions 56, 56A and 56B conform to each other, then joining the flexible printed circuit boards 50 and 60 together to the connection fixing electrode 52.

According to this modified example, it is possible to mount a number of memory devices 13 at positions close to the BGA type integrated circuit 12. Therefore, even when the number of memory devices 13 to be incidentally arranged on the BGA type integrated circuit 12 is large, each memory device 13 may be arranged to be close to the BGA type integrated circuit 12, and the distance between the adjacently arranged BGA type integrated circuits 12 on the printed wiring substrate 11 may be made shorter.

Although the preferred embodiments of the present invention is described in detail as above, the present invention is not limited to the above-described specific embodiment, and a variety of modifications and changes are possible without departing from the scope of the invention recited in claims.

For example, embodiments in which the flexible printed circuit board boards 15 and 50 are applied as the second substrate on which the memory device 13 is mounted is described in above-described each embodiment. However, the second substrate is not limited to the flexible printed circuit board. Alternatively, a rigid-flexible substrate, which is integrally formed by a rigid section of glass epoxy and a flexible section of polyimide, may be used.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a illustrating of the superiority and inferiority of the invention. Although the embodiments of the present inventions have been described in detail, it should be understood that various changes, substitutions, and alterations could be made hereto without departing from the spirit and scope of the invention.

## Claims

1. An electronic component mounting structure, comprising:
a first substrate (11) on which a first component (12) is mounted; and
a second substrate connected to the first substrate,
wherein the second substrate (15) is bent toward the first component (12).

2. The electronic component mounting structure according to claim 1, wherein the second substrate is disposed between the first component and the first substrate.

3. The electronic component mounting structure according to claim 2, wherein the second substrate (15) includes a fixed portion (15A) fixed to the first substrate and an extending portion (15B) extending outwardly from the fixed portion, the extending portion bent by approximately 90 degrees with respect to the first substrate.

4. The electronic component mounting structure according to claim 3, wherein a second component (13) is mounted on the extending portion (15B) of the second substrate.

5. The electronic component mounting structure according to claim 4, wherein a heat dissipation member is installed on the first component, and
the second component is coupled to the heat dissipation member.

6. The electronic component mounting structure according to claim 5, wherein the second component (13) is coupled to a side surface of the heat dissipation member (18) via an adhesive (20).

7. The electronic component mounting structure according to claim 4, wherein a bypass capacitor (14) is mounted on an opposing surface of the second component on the second substrate.

8. The electronic component mounting structure according to claim 3, wherein the extending portion is coupled to a side surface of the first component.

9. The electronic component mounting structure according to claim 1, wherein the second substrate includes a fixed portion fixed to the first substrate and an extending portion extending outwardly from the fixed portion, the extending portion bent by approximately 90 degrees with respect to the first substrate, the fixed portion disposed outside the first component.

10. The electronic component mounting structure according to claim 1, wherein the first substrate includes a printed wiring board; and
the second substrate includes a flexible printed circuit board.

11. The electronic component mounting structure according to claim 1, wherein the first substrate includes a printed wiring board; and
the second substrate includes a rigid-flexible printed circuit board.

12. The electronic component mounting structure according to claim 1, wherein the first substrate is a printed wiring substrate.

13. An electronic component mounting method, comprising:
connecting a second substrate to a first substrate;
mounting a first component on the first substrate; and
bending the second substrate toward the first component on the first substrate.

14. The method according to claim 13, comprising disposing the second substrate between the first component and the first substrate.

15. The method according to claim 13, comprising bending the second substrate by approximately 90 degrees with respect to the first substrate.

16. The method according to claim 13, further comprising mounting a second component on the second substrate.

17. The method according to claim 16, further comprising installing a heat dissipation member on the first component; and coupling the second component to the heat dissipation member.

18. The method according to claim 14, further comprising stacking a plurality of second substrates; and disposing the plurality of second substrates between the first component and the first substrate.
